(19) Europäisches Patentamt / European Patent Office / Office européen des brevets

(11) **EP 2 207 264 B1**

(12) **EUROPEAN PATENT SPECIFICATION**

(45) Date of publication and mention
of the grant of the patent:
**30.10.2013 Bulletin 2013/44**

(51) Int Cl.:
***H03M 1/18*** *(2006.01)*

(21) Application number: **09450005.5**

(22) Date of filing: **09.01.2009**

(54) **Analogue to digital converting**

Analog-Digital-Wandlung

Conversion analogique-numérique

(84) Designated Contracting States:
**AT DE FR GB**

(43) Date of publication of application:
**14.07.2010 Bulletin 2010/28**

(73) Proprietor: **AKG Acoustics GmbH**
**1230 Wien (AT)**

(72) Inventor: **Hannes Breitschädel**
**1070 Wien (AT)**

(74) Representative: **Barger, Werner**
**Mahlerstrasse 9**
**1010 Wien (AT)**

(56) References cited:
**EP-B1- 0 361 315      US-A- 5 777 569**
**US-A- 6 104 329      US-A1- 2007 103 355**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

# EP 2 207 264 B1

**Description**

The invention concerns a method for converting an analog input signal into a digital output signal with at least two analog signal components, whose signal levels differ from each other, being derived from the input signal and the signal components being respectively subjected to an analog-digital conversion. The invention also concerns a device with which this method can be implemented.

There is a need for analog-digital transformation in many areas of digital signal processing, in particular in digital microphony, whereby signals with a dynamic range that is as wide as possible can be transmitted while simultaneously maximizing the signal-to-noise ratio (SNR). Qualitatively high performance A/D converters having a high resolution are used for this purpose. However, they are expensive and they use a lot of power, which is particularly disadvantageous in portable applications, e.g. radio microphones.

The state of the art attempts to circumvent these problems by splitting the analog input signal into two signal components, with the still analog signal components being subjected to different levels of amplification. The signal components present in different signal pathways now having different levels are independently subjected to an A/D conversion. If the level of the signal component, which already has a higher level in comparison with the other signal component because of the different amplification, increases above a threshold that causes clipping in the corresponding A/D converter, a switchover to the lower level signal component or the corresponding signal pathway occurs, in which, due to its lower level, no clipping takes place (as yet) in the A/D converter. This method is also called gain staging.

The advantage of this method is that at least two low-resolution converters can be used in place of one high-resolution converter without thereby limiting or influencing the dynamic range that is available for transmission. The major challenge in this method, however, is posed by switching between the two signal pathways. This requires an extremely precise matching of the digitized signal components to each other regarding both the amplitude and the phase relation between the signal components. Even time shifts in the nanosecond range can cause unwanted interferences at the "junctions" at which one signal component is attached to the other signal component. The effort expended by the complicated matching of the signal components is not related to the simplification of the actual A/D conversion.

The method described above is, for example, described in "The Digitally Interfaced Microphone", S. Peus, O. Kern Neumann GmbH, Berlin, presented at the 110th AES Convention 2001 May 12-15, Amsterdam, The Netherlands.

Both of the aforementioned publications disclose another method for the A/D conversion of signals. This method too is based on replacing an expensive A/D converter having a high resolution with two A/D converters having a low resolution, which consume less power in combination. Contrary to the methods described above, signal components that are produced from the original analog input signal after passing through a nonlinear network are directed into the two signal pathways. One of the signal components is distorted so that it essentially contains no useful information from the input signal below a threshold signal level. The other signal component results from the addition of the input signal with correct sign to the distorted signal component (i.e. the distorted signal is subtracted from the input signal), whereby a complementary distorted signal shape is produced. After the A/D conversion of the two signal components, the reconstruction of the original signal occurs via the addition of the signal components, because the distortion of the signal components is always accurately complementary and thus resulting in an undistorted digital output signal. Because of the decrease in amplitude due to the subtraction of the distorted signal, the corresponding A/D converter does not reach the clipping level.

The device for analog-to-digital conversion disclosed in the US 5,777,589 A includes a plurality of amplifiers for amplifying a common input analog signal with predetermined different gains respectively. Herby, a plurality of analog-to-digital converters are used to convert the output signals of the amplifiers into corresponding first digital signals and for outputting the first digital signals respectively. A decision is made as to whether or not each of the first digital signals outputted by the analog-to-digital converters is in at least one of a given clipped state and a given full-scale over state. The first digital signals from the analog-to-digital converters are corrected into respective second digital signals representing substantially equal levels. When none of the first digital signals is in at least one of the given clipped state and the given full-scale over state one is selected out of all the second digital signals as a final digital output signal. When at least one of the first digital signals is in at least one of the given clipped state and the given full-scale over state one is selected out of the second digital signals unrelated to the at least one of the first digital signals as a final digital output signal.

It is the object of the present invention to improve the initially described method and to thus relieve the problems of switching between the signal paths. Regarding the aforementioned method based on replacing an expensive A/D converter having a high resolution with two A/D converters having a low resolution, disadvantages which occur due to the nonlinear network and its amplification, particularly with high signal and noise amplitudes, are relieved.

This object is achieved with a method of the type described above in that the digitized signal components are weighted with a variable weighting factor and the weighted signal components are added together.

The weighting and subsequent merging respectively addition of the signal components makes it possible to react to the changing characteristics of the analog input signal and thus also of the analog signal components in a simple manner. By means of the variable weighting factor, it is possible to smoothly crossfade the signal components. The fractional content of the signal components in the resulting output signal can thus be adapted to existing conditions.

It is basically possible to draw upon any determinable property of one of the two signal components or of the input signal as well as a criterion for a change in the weighting of the signal components, e.g. the signal magnitude, the signal-to-noise ratio, harmonic distortion, clipping, etc. The level of one of the two signal components has been found to be particularly advantageous and reliable as a reference parameter while the magnitude of the signal is nevertheless directly associated with the occurrence of clipping. Therefore, as soon as the magnitude of the signal exceeds a preset threshold value and clipping is expected to occur, the signal components are crossfaded, i.e. the weighting of the signal components in the resulting output signal changes. The crossfading occurs continuously, i.e. by a constant adjustment of the weighting factor, whereby the transition becomes smooth.

In a preferred embodiment, the change in the weighting factor is time-delayed. This is in particular done if the signal level decreases again after reaching a critical threshold value and if the weighting factor of the more amplified signal component is again to be represented more strongly in the output signal. Due to the time delay, i.e. a slow adjustment of the weighting, the crossfading is no longer perceptible to the listener.

In the following the invention is described in greater detail based on the drawings.

Figure 1 shows a schematic drawing of the generation and digitization of two signal components having different levels,
Figure 2 shows a block diagram of a circuit of this invention,
Figure 3 shows an extension of the idea of this invention to more than two signal pathways.

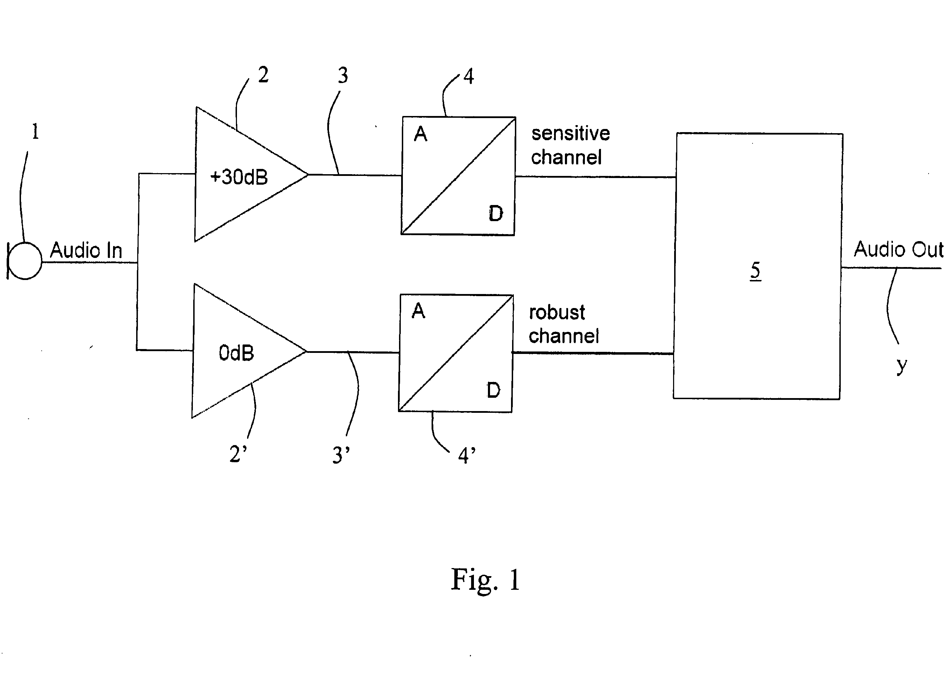

Figure 1 shows in a schematic drawing that two signal components having different levels are conveyed into the signal paths 3, 3' from an analog input signal (audio in), which can, for example, be a signal from a microphone 1. In the example shown here, this occurs through differing amplifications by the amplifiers 2, 2', whereby a stronger amplification occurs in the signal pathway 3 than in the signal pathway 3'. It would also be possible to attenuate one of the two signal components, e.g. via a voltage divider.

The two analog signal components are preferably essentially shifted to the same phase and a constant magnitude ratio over the entire transmitted frequency range. This has a positive effect, in particular at low frequencies (< 50-60 Hertz), in that the emergence of unwanted artifacts at low frequencies is prevented during the subsequent merging of the digitized signal components according to this invention.

The signal pathway 3, in which the signal component has the higher level, is hereafter also called the "more sensitive" signal pathway and the signal pathway 3', in which the signal component has a lower level, is also called the "robust" signal pathway. Both signal components are thereafter digitized in the respective A/D converters 4 and 4' and are subjected to further processing in a processing unit 5 and are merged so as to generate the output signal y.

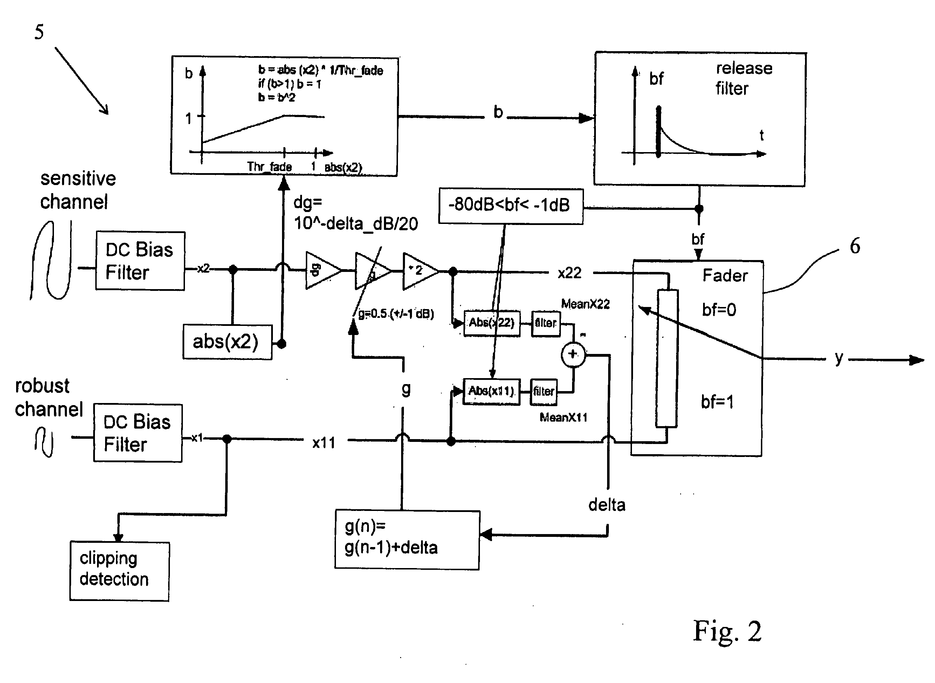

Figure 2 shows the internal workings of the processing unit 5 and thus the continuation of the two signal pathways 3, 3'. The level of the signal component $x2$ in the sensitive channel 3 is now already higher by a constant factor (e.g. between 10 and 40 dB) than that of the signal component $x1$ in the robust channel 3'. If the sensitive channel reaches clipping level, then crossfading to the other (robust) channel occurs. It is intended to achieve a higher ADC resolution and to create a system with an SNR of approximately 120 dB defined by the external wiring. The disadvantage of the bad SNR of only approximately 85 dB of the individual ADCs is circumvented by the smooth crossfading of the sensitive and the robust channel.

The process in the signal processor after the A/D transformation is described hereafter: each of the digitized signal components $x11$, $x22$ are weighted with a weighting factor bf or 1-bf and added in a weighting unit 6, also called a fader, whereby the output signal y of the device of this invention is formed:

$$y = x22 * (1-bf) + x11 * bf,$$

where the weighting factor bf can have values between 0 and 1.

In the present example, the signal $x1$ is identical to $x11$, while $x22$ is obtained from the signal $x2$ by a correction in signal level. Before the two signal components are merged in the weighting unit 6, they must again have the same level in order to avoid unwanted variations in signal level in the output signal y when they are merged. For this purpose, $x2$ is appropriately attenuated with the attenuator dg. It is just as possible to amplify $x1$ instead, or the appropriate adjustment could take place in the fader with weighting factors modified accordingly.

Description of the appropriate algorithm:

x2 is the output signal of the ADC in the sensitive channel 3, x1 is the signal of the robust channel 3'. The signal x22 is produced from x2 by multiplication with a constant gain dg. The constant gain corresponds to the difference in signal level x1:x2. In the signal flow, a variable gain g, which has the function of adaptibly adjusting possible tolerances due to external component variations, follows the constant gain dg. A typical control range would be +/-1 dB. Since, in the present embodiment, the signal processing algorithm is performed in a fixed point computer, which does not permit multiplications with numbers greater than 1, this adaptive gain is achieved in two steps. The first step operates with a variable of about 0.5 and is followed by a fixed amplification by a factor of 2:

$$x22 = x2 * dg * g * 2$$

The weighting factors bf and 1-bf are calculated as a function of the level of one of the signal components. In the present example, the level of the signal component x2 in the sensitive channel 3 is used as the reference parameter. The magnitude abs(x2) can, for example, be determined in the form of the absolute value, the RMS (root mean square) of the peak value or the rectification value. Such level measurements are well-known to the specialist. An intermediate variable b is now calculated based on the signal x2:

$$b = (abs(x2) * 1/Thr\_fade) \wedge 2$$

if (b>1) b = 1
where Thr_fade defines an adjustable threshold value, which essentially corresponds to the upper range of the A/D converter, but preferably lies somewhat below this range (e.g. about -6 dB), in order make it possible to crossfade in time to the robust channel 3', so that the occurrence of clipping in the ADC does not become audible in the output signal y.

If the level abs(x2) of the signal component x2 is greater than the threshold value Thr_fade, then b = 1, thereunder the intermediate variable b, follows a square characteristic, so that the intermediate parameter b decreases continuously quadratically with the falling signal magnitude abs(x2).

The weighting factor bf is produced from the intermediate variable b by a smoothing filter, with bf being rapidly adjusted with rising b, while it decreases according to a first order low-pass filter with falling b. This behavior is comparable with that of a release filter of an audio compressor. The smoothing filter can be described with the following algorithm.

$$bf = bf * Coeff;$$

If (b>bf) bf = b;
where

$$coeff = e\wedge(-2.2 / (SampleRate * TimeConst))$$

SampleRate is the sampling rate of the ADC and the time response is described by the constant TimeConst. TimeConst is typically selected at 0.1 seconds, from which a bf value of 0.9995 is obtained.

The algorithm described above represents a possible implementation of the invention. The algorithm has the following advantages: because of the square dependence of the weighting factors bf and respectively 1-bf on the signal magnitude abs(x2), the system reacts very rapidly to increasing signal level and the weighting of the signal components in the resulting output signal is changed rapidly. If the signal magnitude abs(x2) decreases again, the weighting factors bf or respectively 1-bf are updated with a time delay. This inertia of the system with decreasing signal strength ensures a smooth crossfading of the two signal paths and ensures that the crossfading process does not become audible to the user. The selection of the time constants TimeConst of approximately 0.1 s is intended to execute the crossfading within the masking interval of human auditory perception.

The weighting unit 6 (the fader) is then controlled with the weighting factors bf or respectively 1-bf. In the limiting case, if bf = 1, only the signal component x11 of the robust channel 3' arrives at the output y. In the other limiting case, if bf = 0, only the signal component x22 of the sensitive channel 3 arrives at the output y. Smooth crossfading occurs in between.

In a preferred embodiment, a provision for the adaption of a previously mentioned gain g is made, which has the function of adaptively adjusting possible tolerances due to component variations:

The average value MeanX11 or MeanX22 of the respective absolute values abs(x11) or abs(x22) is determined from the signals x11 and x22. The two average values are subtracted from each other resulting in the difference delta which is used to modify the Gain g(n) (closed loop), where:

$$delta = MeanX11 - MeanX22$$

$$g(n) = g(n-1) + delta$$

n is the corresponding sampled value.

To avoid side effects and misadaptions, the gain g(n) is only adjusted if the weighting factor bf is within a range of, for example, 0.0001 to 0.9.

Because of the A/D conversion with a non-ideal ADC the signals contain a DC component. In order to exclude malfunctions from subsequent parts of the algorithm, this component is removed on the input side by means of an appropriate filter, a DC bias filter, which behaves like a high-pass filter.

As mentioned previously, certain actions are preferred in the analog part of the circuit to make it possible to also particularly transmit low frequencies better via the method of this invention. To guarantee the correct functioning of the following algorithm, it is important for the two analog signal components to have a level ratio that is as constant as possible over all frequencies as well as no phase shift. Phase shifts and frequency dependent differences in signal level act as distorting factors at very low audio frequencies since the fader follows the signal shape of the audio signal directly in this case.

The invention is naturally not limited to the embodiment that is shown. It is in particular possible to build one or more latency components into the signal paths. This enables a somewhat time-delayed increase of the weighting factor bf, so that a smooth crossfading of the signal paths is enabled before clipping occurs.

It is also possible for other algorithms to act as the basis of the generation of the weighting factors as a function of one of the signal components. In particular, the square dependency of the weighting factors on the signal level is not mandatory. The time delay in adjusting the weighting factor can also behave differently than a 1st order low-pass filter.

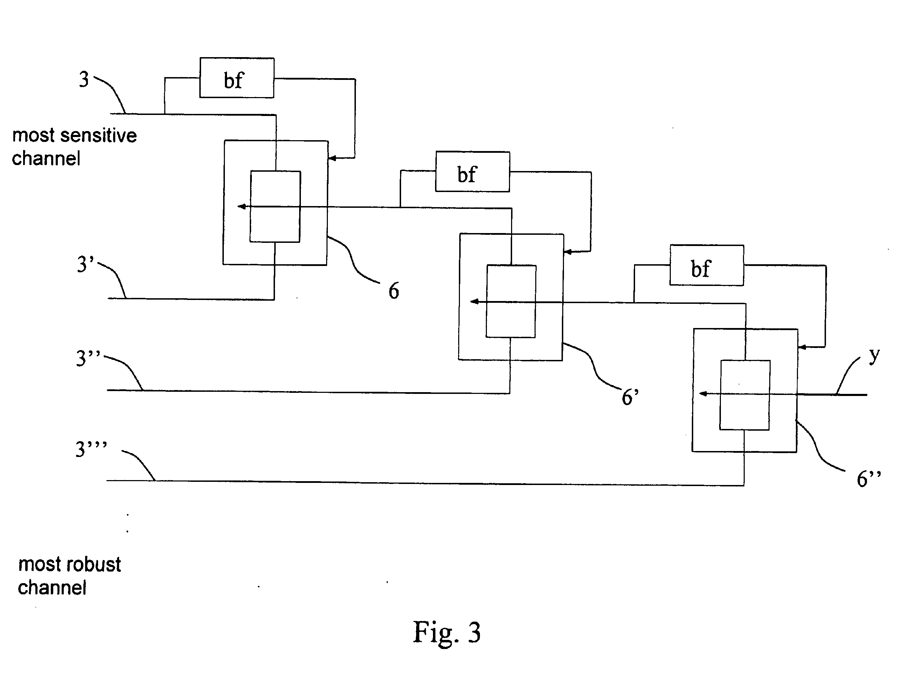

As an extension of this invention, a further variant shown in Figure 3 contains several signal paths 3, 3', 3", 3'''. In this example, more than two signal components are derived from the analog input signal, with each signal component having a different signal level. Starting from channel 3, also called the "most sensitive channel", having the highest signal level, it is thus possible to successively crossfade to channels with respectively lower signal strengths. Figure 3 shows a possible way to implement this idea, with the signal paths 3, 3', 3", 3''' and the corresponding weighting units 6, 6', 6" being nested so as to respectively merge two signal paths. If the most sensitive channel 3 reaches the clipping level, blending over to the next channel 3' having a lower signal strength occurs. If the latter also reaches the clipping level, crossfading to channel 3" having the next-lower signal strength occurs, and so on.

## Claims

1. Method for converting an analog input signal into a digital output signal, where at least two analog signal components which differ in signal level are derived from the analog input signal, and the respective signal components are subjected to an analog-digital conversion, for providing digitized signal components, which are weighted with a variable weighting factor and the weighted signal components are added to each other, wherein the weighting factor is changed as a function of the level of one of the digitized signal components, with the weighting factor for the signal component having a higher signal level decreasing with increasing signal level, **characterized by the fact that** the weighting factor for the signal component having a higher signal level depends on the square of the signal level of one of the digitized signal components.

2. Method according to Claim 1, **characterized by** the fact that the weighting factor for the signal component having a higher signal level increases in a time-delayed manner with decreasing signal level.

**3.** Method according to Claim 1, **characterized by** the fact that the time response of the weighting factor corresponds to that of a first-order low-pass filter.

**4.** Method according to one of Claims 1 to 3, **characterized by** the fact that, prior to the analog-digital conversion, the signal components essentially have the same phase and a constant level ratio over the entire frequency range.

**5.** Method according to one of Claims 1 to 4, **characterized by** the fact that a latency component is inserted between the analog-digital conversion and the joining of the digitized signal components, and the modification of the weighting factors as a function of the signal strength of one of the signal components occurs in a time-delayed manner.

**6.** Method according to one of Claims I to 5, **characterized by** the fact that an adjustment in the signal level of the signal components occurs between the analog-digital conversion and the weighting of the signal components.

**7.** Device for converting an analog input signal into a digital output signal having an analog input channel branching into at least two signal paths (3, 3') each of which contains an analog-digital converter (4, 4') for providing respective digitized signal components the at least two signal paths (3, 3') are joined into an output channel (y), said device further including a weighting unit (6), which imposes a variable weighting factor (1-bf, bf) on the digital signal components before they are joined, and a device for determining the signal level in one of the signal paths and which is connected with the weighting unit (6) for the purpose of modifying the weighting factor (1-bf, bf) as a function of the determined signal level with the weighting factor for the signal component having a higher signal level decreasing with increasing signal level, **characterized by** the fact that the weighting factor for the signal component having a higher signal level depends on the square of the signal level of one of the digitized signal components.

**8.** Microphone (1), in particular a radio microphone, **characterized by** the fact that the microphone (1) contains a device for the analog-digital conversion of an audio signal according to Claim 7.

**Patentansprüche**

**1.** Verfahren zum Umwandeln eines analogen Eingangssignals in ein digitales Ausgangssignal, wobei aus dem analogen Eingangssignal mindestens zwei analoge Teilsignale abgeleitet werden, die zueinander einen Pegelunterschied aufweisen, und die Teilsignale jeweils einer Analog-Digital-Wandlung unterzogen werden, um digitalisierte Teilsignale zu erhalten, die mit einem veränderlichen Gewichtungsfaktor gewichtet werden und die gewichteten Teilsignale miteinander addiert werden, wobei der Gewichtungsfaktor in Abhängigkeit vom Pegel eines der digitalisierten Teilsignale verändert wird, wobei der Gewichtungsfaktor für das Teilsignal, das einen höheren Pegel aufweist, mit zunehmendem Pegel abnimmt, **dadurch gekennzeichnet, dass** der Gewichtungsfaktor für das Teilsignal, das einen höheren Pegel aufweist, vom Quadrat des Pegels eines der digitalisierten Teilsignale abhängt.

**2.** Verfahren nach einem der Ansprüche 1 **dadurch gekennzeichnet, dass** der Gewichtungsfaktor für das Teilsignal, das einen höheren Pegel aufweist, mit abnehmendem Pegel zeitverzögert zunimmt.

**3.** Verfahren nach Anspruch 1, **dadurch gekennzeichnet, dass** das Zeitverhalten des Gewichtungsfaktors jenem eines Tiefpasses erster Ordnung entspricht.

**4.** Verfahren nach einem der Ansprüche 1 bis 3, **dadurch gekennzeichnet, dass** die Teilsignale vor der Analog-Digital-Wandlung im Wesentlichen über den gesamten Frequenzbereich gleiche Phase und ein konstantes Pegelverhältnis aufweisen.

**5.** Verfahren nach einem der Ansprüche 1 bis 4, **dadurch gekennzeichnet, dass** zwischen der Analog-Digital-Wandlung und dem Zusammenführen der digitalisierten Teilsignale ein Latenzglied eingefügt ist, und die Veränderung der Gewichtungsfaktoren in Abhängigkeit vom Pegel eines der Teilsignale zeitverzögert erfolgt.

**6.** Verfahren nach einem der Ansprüche 1 bis 5, **dadurch gekennzeichnet, dass** zwischen der Analog-Digital-Wandlung und dem Gewichten der Teilsignale eine Pegelanpassung der Teilsignale erfolgt.

**7.** Vorrichtung zum Umwandeln eines analogen Eingangssignals in ein digitales Ausgangssignal, mit einem analogen Eingangskanal, der in mindestens zwei Signalpfade (3, 3') verzweigt, die jeweils einen Analog-Digital-Wandler (4, 4') zum Erstellen entsprechend digitalisierter Teilsignale aufweisen, wobei die zumindest zwei Signalpfade (3, 3') in einen Ausgangskanal (y) zusammengeführt werden, die Vorrichtung enthält weiters eine Gewichtungseinheit (6), die die digitalen Teilsignale vor der Zusammenführung mit einem veränderlichen Gewichtungsfaktor (1-bf, bf) beaufschlagt, und eine Einrichtung zur Bestimmung des Pegels in einem der Signalpfade, die mit der Gewichtungseinheit (6) zum Zwecke der Veränderung des Gewichtungsfaktors (1-bf, bf) in Abhängigkeit vom ermittelten Pegel verbunden ist, wobei der Gewichtungsfaktor für das Teilsignal, das einen höheren Pegel aufweist, mit zunehmendem Pegel abnimmt, **dadurch gekennzeichnet, dass** der Gewichtungsfaktor für das Teilsignal, das einen höheren Pegel aufweist, vom Quadrat des Pegels eines der digitalisierten Teilsignale abhängt.

8.   Mikrophon (1), insbesondere Funkmikrophon, **dadurch gekennzeichnet, dass** das Mikrophon (1) zur Analog-Digitalwandlung eines Audiosignals eine Vorrichtung nach Anspruch 7 enthält.

**Revendications**

1.   Procédé pour convertir un signal d'entrée analogique en un signal de sortie numérique, où au moins deux composantes de signal analogique ayant un niveau de signal différent, sont dérivées du signal d'entrée analogique, et les composantes de signal respectives sont soumises à une conversion analogique-numérique pour fournir des composantes de signal numérisées qui sont pondérées avec un facteur de pondération variable et les composantes de signal pondérées sont ajoutées les unes aux autres ; où le facteur de pondération est changé en fonction du niveau d'une des composantes de signal numérisées ; le facteur de pondération pour la composante de signal ayant un niveau supérieur de signal qui diminue lorsque le niveau de signal augmente, **caractérisé par le fait que** le facteur de pondération pour la composante de signal ayant un niveau supérieur de signal dépend du carré du niveau de signal d'une des composantes numérisées de signal.

2.   Procédé selon la revendication 1, **caractérisé par le fait que** le facteur de pondération pour la composante de signal ayant un niveau de signal supérieur, augmente de façon retardée dans le temps avec un niveau de signal qui diminue.

3.   Procédé selon la revendication 1, **caractérisé par le fait que** la réponse temporelle du facteur de pondération correspond à un filtre passe-bas du premier ordre.

4.   Procédé selon une des revendications 1 à 3, **caractérisé en ce qu'**avant la conversion analogique-numérique, les composantes de signal ont essentiellement la même phase et un ratio de niveau constant sur toute la zone de fréquence.

5.   Procédé selon une des revendications 1 à 4, **caractérisé par le fait qu'**une composante à latence est insérée entre la conversion analogique-numérique et la liaison des composantes numérisées de signal, et la modification des facteurs de pondération en fonction de l'intensité du signal d'une des composantes de signal a lieu de façon retardée.

6.   Procédé selon une des revendications 1 à 5, **caractérisé en ce qu'**un ajustement du niveau de signal des composantes de signal a lieu entre la conversion analogique-numérique et la pondération des composantes de signal.

7.   Dispositif pour convertir un signal d'entrée analogique en un signal de sortie numérique ayant un canal d'entrée analogique se ramifiant dans au moins deux trajets de signal (3, 3'), chacun d'entre eux contenant un convertisseur (4, 4') analogique-numérique pour fournir les composantes numérisées respectives de signal ; les au moins deux trajets de signal (3, 3') se rejoignent dans un canal de sortie (y), ledit dispositif comprenant, en outre, une unité de pondération (6) qui impose un facteur de pondération variable (1-bf, bf) aux composantes numériques de signal avant qu'elles ne se rejoignent, et un dispositif pour déterminer le niveau de signal dans l'un des trajets de signal, lequel dispositif est relié à l'unité de pondération (6) dans le but de modifier le facteur de pondération (1-bf, bf) en fonction du niveau déterminé de signal ; le facteur de pondération pour la composante de signal ayant un niveau supérieur de signal qui diminue lorsque le niveau de signal augmente, **caractérisé en ce que** le facteur de pondération pour la composante de signal ayant un niveau de signal plus élevé dépend du carré du niveau de signal d'une des composantes numérisées du signal.

8.   Microphone (1), en particulier un microphone radio, **caractérisé par le fait que** le microphone (1) contient un dispositif pour la conversion analogique-numérique d'un signal audio selon la revendication 7.

7

Fig. 1

Fig. 2

Fig. 3

EP 2 207 264 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

• US 5777589 A

### Non-patent literature cited in the description

• **S. PEUS ; O. KERN NEUMANN GMBH.** The Digitally Interfaced Microphone. *110th AES Convention,* 12 May 2001